# EUROPÄISCHE PATENTANMELDUNG

(11) **EP 0 996 147 A1**
(43) Veröffentlichungstag der Anmeldung: **26.04.2000**
(21) Anmeldenummer: 99120334.0
(22) Anmeldetag: 12.10.1999
(51) Int. Cl.: H01L 21/316, H01L 21/304

(54) **Verfahren zum Herstellen eines Halbleiterchips durch anodischer Oxidation**

(30) Priorität: 21.10.1998 DE 19848460
(71) Anmelder: Micronas Intermetall GmbH, 79108 Freiburg (DE)
(72) Erfinder: Schröder, Johann, Dipl.-Ing., 79263 Simonswald (DE)
(74) Vertreter: Schmitt, Hans, Dipl.-Ing.

(57) **Zusammenfassung**

Bei einem Verfahren zum Herstellen eines Halbleiterchips (3) wird ein Wafer (1) mit den für die elektrische Funktion des Halbleiterchips (3) erforderlichen Strukturen (2) versehen. Danach werden im Umgrenzungsbereich des Halbleiterchips (3) dessen elektrisch leitfähige Seitenwandungen zumindest bereichsweise freigelegt und durch anodische Oxidation mit einer elektrisch isolierenden Isolationsschicht (10) versehen.

## Beschreibung

Die Erfindung betrifft ein Verfahren zum Herstellen eines Halbleiterchips.

Zum gleichzeitigen Herstellen einer Vielzahl von Halbleiterchips ist es aus der Praxis bereits bekannt, einen Wafer mit einer der Anzahl der herzustellenden Halbleiterchips entsprechenden Anzahl Strukturen zu versehen, die jeweils für die Funktion der einzelnen Halbleiterchips erforderlich sind. Die Strukturen werden mit aus derHalbleitertechnikbekanntenStrukturierungsverfahrenhergestellt, beispielsweise durch Auftragen einer Photomaske und anschließendes Naß- oder Trockenätzen des Wafers und/oder durch Bedampfen des Wafers. Nach Fertigstellung der Strukturen werden die einzelnen Halbleiterchips durch Zerteilen des Wafers von dem Waferverbund abgetrennt und vereinzelt.

Bei solchen Halbleiterchips besteht das Problem, daß die quer zur Chipebene angeordneten, aus elektrische leitendem Halbleitermaterial bestehenden Seitenwandungen des Halbleiterchips elektrisch isoliert werden müssen, damit die Funktion des Halbleiterchips gewährleistet ist. So kann beispielsweise eine nicht ausreichend isolierte Seitenwandung bei einem in MESA-Technik strukturierten Halbleiterchip dazu führen, daß Feuchtigkeit an die im inneren der MESA-Struktur befindlichen pn-Übergänge gelangt und dort Kriechströme zwischen den unterschiedlich dotierten Halbleiterschichten verursacht.

Es ist zwar bereits bekannt, einen Halbleiterchip in ein Kunststoffgehäuse einzugießen, um den Halbleiterchip vor einem Kontakt mit Feuchtigkeit oder anderen elektrische leitfähigen Medien zu schützen. Bei bestimmten Anwendungen, wie beispielsweise bei Halbleiterchips, die als oberflächenaktive Sensoren ausgebildete Strukturen zum Messen von Ionenkonzentrationen in flüssigen Medien aufweisen, kommt jedoch eine vollständige Kapselung des Halbleiterchips nicht in Betracht. Bei solchen Halbleiterchips muß nämlich die flachseitige Oberfläche des Halbleiterchips für das zu untersuchende Medium zugänglich sein, damit die dort angeordnete oberflächenaktive Struktur mit dem zu untersuchenden Medium in Berührung gelangen kann. Entsprechendes gilt für Halbleiterchips, an deren Oberfläche biologische Zellen adhärent angelagert werden sollen, zum Beispiel um an den Zellen Messungen durchzuführen und/oder um die Zellen durch elektrische Felder zu stimulieren. Solche Halbleiterchips werden beispielsweise in sogenannten Bio-Sensoren verwendet.

Bei einem anderen aus der Praxis bekannten Verfahren zum Herstellen eines Halbleiterchips wird der Wafer zunächst mit den für die Funktion der einzelnen Halbleiterchips erforderlichen Strukturen versehen und danach werden in die flachseitige Oberfläche des Wafers rinnenartige Vertiefungen eingebracht, welche die einzelnen Halbleiterchips jeweils umgrenzen. Dann wird auf die die rinnenartigen Vertiefungen aufweisende Oberfläche des Wafers eine thermoplastische, elektrisch isolierende Kunststoffmasse aufgetragen und mit einem Rakel glattgezogen. Dabei füllt die Kunststoffmasse die Vertiefungen vollständig aus. Nach dem Aushärten der Kunststoffmasse wird der Wafer zum Vereinzeln und Abtrennen der Halbleiterchips aus dem Waferverbund im Bereich der Vertiefungen zerteilt. Die Halbleiterchips weisen dann an ihren Seitenflächen bereichsweise eine elektrisch isolierende Kunststoffschicht auf, die beispielsweise dort befindliche pn-Übergänge abdecken kann. Ein Nachteil dieses Verfahrens besteht darin, daß die thermoplastische Kunststoffmasse beim Auftragen auf den Wafer und beim Abziehen mit den Rakel außer mit den Vertiefungen auch mit der flachseitigen, der für die Funktion des Halbleiterchips erforderliche Struktur aufweisenden Oberfläche der Halbleiterchips in Berührung kommt, wobei es zu einer chemischen und/oder physikalischen Veränderung der Struktur kommen kann. Bei einem unvollständigen Entfernen des thermoplastischen Kunststoffmaterials von den außerhalb der Vertiefungen befindlichen Oberflächenbereichen des Halbleiterchips wird außerdem die nachfolgende Montage des Halbleiterchips auf einem Träger, beispielsweise durch Bonden, Löten oder Kleben wesentlich erschwert.

Bei dem aus EP 0 148 687 A1 bekannten Verfahren wird auf einen Wafer eine Mesa-Struktur für einen als Photodiode ausgebildeten Halbleiterchip aufgebracht. Dabei wird der Wafer zunächst mit einer photoempfindlichen Schicht versehen und anschließend werden im Umgrenzungsbereich des Halbleiterchips dessen Seitenwandungen durch Einbringen von Mesagräben bereichsweise freigelegt. Danach wird die Oberfläche des Wafers durch anodische Oxidation mit einer Isolationsschicht versehen. Auf diese werden eine metallische Schicht, eine Schicht aus einem dielektrischen Material sowie elektrische Kontakte aufgebracht. Das Verfahrens hat den Nachteil, daß zum Verbinden der Anschlußkontakte mit der photoempfindlichen Schicht in die anodisch oxidierte Schicht und die dielektrische Schicht eine Öffnung eingebracht werden muß, wozu ein zusätzlicher Maskierungs- und Ätzschritt erforderlich ist. Ungünstig ist außerdem, daß nach dem Ablösen des Halbleiterchips von dem Wafer, das entlang der Talsohlen der Mesagräben erfolgt, die für die Funktion des Halbleiterchips erforderliche metallische Schicht an der Seitenfläche des Halbleiterchips freiliegt und dort nicht elektrisch isoliert ist.

Auch bei den aus CHANG, E.Y., et al., IR: IEEE Transactions an Semiconductor Manufactoring, Vol. 4, No. 1, 1991, S. 66-68 und US 4 839 300 bekannten Verfahren werden Seitenflächen eines Halbleiterchips freigelegt. Bei diesen Verfahren ist eine elektrische Isolation der freigelegten Seitenflächen nicht vorgesehen.

Man kennt auch bereits ein Verfahren zum Herstellen eines Halbleiterchips, bei dem vor dem Strukturieren des Wafers mit den für die Funktion der Halbleiterchips erforderlichen Strukturen in die flachseitige Oberfläche des Wafers zunächst rinnenartige Vertiefungen eingebracht werden und die Oberfläche des Wafers anschließend durch eine Temperaturbehandlung in einer sauerstoffhaltigen Atmosphäre mit einer elektrisch isolierenden Halbleiter-Oxid-Schicht versehen wird. Diese wird dann außerhalb der rinnenartigen Vertiefungen nach Aufbringen einer Lackmaske durch Ätzen entfernt. Anschließend werden die für die Funktion der Halbleiterchips erforderlichen Strukturen erzeugt. Dieses Verfahren hat jedoch den Nachteil, daß der Wafer bei der Herstellung der für die Funktion der Halbleiterchips erforderlichen Strukturen aufgrund der dann bereits vorhandenen Vertiefungen nur noch eine vergleichsweise geringe mechanische Stabilität aufweist. Bei den einzelnen, für die Strukturierung erforderlichen Bearbeitungsschritten und/oder beim Transport des Wafers zu den unterschiedlichen Bearbeitungsstationen kann es daher zu einer mechanischen Beschädigung des Wafers kommen, was bei einer fabrikmäßigen Herstellung der Halbleiterbauelemente zu nicht unerheblichen Produktionsausfallzeiten führen kann, beispielsweise wenn ein Wafer in einer Vakuumkammer zerbricht und die Vakuumkammer dann zum manuellen Entnehmen des Wafers belüftet werden muß. Ein weiterer Nachteil des Verfahrens besteht darin, daß die die Vertiefungen aufweisende Oberfläche des Wafers für eine Photolithographische Herstellung der für die Funktion der Halbleiterchips erforderlichen Struktur ungünstig gestaltet ist. So kann es beispielsweise beim Auftragen eines Photolacks auf den rotierenden Wafer nach dem sogenannten Schleuderverfahren zu einer ungleichmäßigen Ausbildung des Lackfilms kommen.

Aus DE 43 05 296 C2 ist ferner ein Verfahren zum Herstellen von Halbleiterchips in Mesa-Technik bekannt, bei dem auf einem Wafer zuerst die für die Funktion der Halbleiterchips jeweils erforderlichen Strukturen erzeugt werden. Danach werden im Umgrenzungsbereich der Halbleiterchips deren Seitenwandungen durch Einbringen von Mesagräben in den Wafer bereichsweise freigelegt. Anschließend wird auf die flachseitige Oberfläche des Wafers durch CVD-Oxidation eine Siliziumdioxid-Schicht aufgebracht. Danach werden die mit ihrer der Struktur abgewandten Rückseiten an einer Trägerfolie anhaftenden Halbleiterchips durch Sägeschnitte entlang der Talsohlen der Mesagräben vom Wafer abgetrennt. Dabei wird die Trägerfolie nicht durchtrennt. Die nach dem Sägen weiterhin an der Trägerfolie anhaftenden Halbleiterchips werden mit einem Ätzmittel in Berührung gebracht, um die durch die Sägeschnitte freigelegten Seitenwandungen der Halbleiterchips aufzurauhen. Anschließend wird in einem weiteren Fertigungsschritt die Siliziumdioxid-Schicht, welche die für die Funktion der Halbleiterchips erforderlichen Strukturen vor dem Angriff des Ätzmittels geschützt hat, entfernt. Das Verfahren hat den Nachteil, daß die elektrisch leitfähigen Bereiche der für die Funktion des jeweiligen Halbleiterchips erforderlichen Struktur nach Fertigstellung des Halbleiterchips freiligen und elektrisch nicht isoliert sind.

Es besteht deshalb die Aufgabe, ein Verfahren der eingangs genannten Art zu schaffen, das eine einfache Herstellung eines Halbleiterchips ermöglicht. Außerdem soll beim Aufbringen der Isolationsschicht auf die Seitenwandungen des Halbleiterchips eine Beeinträchtigung der für die Funktion des Halbleiterchips erforderlichen Struktur vermieden werden.

Diese Aufgabe wird mit den Merkmalen des Patentanspruchs 1 gelöst.

Bei dem erfindungsgemäßen Verfahren wird der Wafer also zunächst mit den für die elektrische Funktion des Halbleiterchips erforderlichen Struktur versehen, die beispielsweise einen oberflächenaktiven Sensor, einen Transistor, eine Elektrode und/oder einen Interdigitalkondensator umfassen kann. Danach werden quer zur Erstreckungsebene des Halbleiterchips angeordnete Seitenwandungen des Halbleiterchips zumindest bereichsweise freigelegt. Zum anodischen Oxidieren der Oberfläche dieser Seitenwandungen wird der Halbleiterchip mit einem Elektrolyten in Verbindung gebracht, beispielsweise mit Schwefelsäure, Oxalsäure oder in Wasser gelöstem Kaliumpermanganat. Dabei wird zwischen dem Elektrolyt und dem an den Seitenwandungen freiliegenden, elektrisch leitfähigen Halbleitersubstrat eine Anodisierspannung angelegt.

Bei dem erfindungsgemäßen Verfahren ist der Wafer bzw. der daraus hergestellte Halbleiterchip sowohl vor als auch nach dem Aufbringen der elektrischen Isolationsschicht gut prozessierbar. Da die anodische Oxydation des Wafers nur an den elektrisch leitfähigen Seitenflächen des Wafers erfolgt, ist das Verfahren selbstjustierend, d.h. die Beschichtung erfolgt nur dort, wo sie erwünscht ist. Bei Halbeiterchips, die eine elektrisch oberflächenaktive Struktur aufweisen (z.B. Sensoren), wird dadurch beim Beschichten der Seitenwandungen des Halbleiterchips mit der elektrischen Isolationsschicht eine Beeinträchtigung der oberflächenaktiven Struktur oder deren Funktion vermieden. Da die anodische Oxydation bei Raumtemperatur durchgeführt werden kann, entfällt außerdem eine Schädigung der elektrisch aktiven Halbleiter-Strukturen durch Wärmebehandlung. Gegenüber einer mechanisch aufgebrachten Isolationsschicht weist die durch anodische Oxydation hergestellte Isolationsschicht außerdem eine bessere Feuchtigkeitsbeständigkeit auf, da die Isolationsschicht durch chemische Umwandlung aus dem Halbleitermaterial selbst hergestellt ist und deshalb besonders gut mit diesem verbunden ist. Das erfindungsgemäße Verfahren ist zudem einfach durchführbar.

Eine Ausführungsform der Erfindung sieht vor, daß die Seitenwandungen des Halbleiterchips durch Einbringen einer rinnenartigen Vertiefung in eine flachseitige Oberfläche des Wafers freigelegt wird, daß der Wafer danach an den Seitenwandungen anodisch oxidiert wird und daß der Wafer anschließend zum Abtrennen des Halbleiterchips vom Wafer entlang der den Halbleiterchip umgrenzenden rinnenartigen Vertiefung zerteilt wird. Bei dieser Ausführungsform des Verfahrens werden vorzugsweise zunächst sämtliche, die auf dem Wafer befindlichen Halbleiterchips umgrenzende Vertiefungen in die Oberfläche des Wafers eingebracht und erst danach wird der Wafer mit dem Elektrolyten in Verbindung gebracht, beispielsweise indem der Elektrolyt an der Waferoberfläche deponiert wird. Die Isolierschichten an den einzelnen, die Halbleiterchips jeweils umgrenzenden Vertiefungen weisen dadurch jeweils die gleiche Schichtdicke auf. Außerdem bleibt der Waferverbund während des anodischen Oxidierens der Seitenwandungen des Halbleiterchips erhalten.

Bei einer vorteilhaften Ausführungsform des Verfahrens erfolgt das Freilegen der anodisch zu oxidierenden Seitenwandungen und/oder das Zerteilen des Wafers entlang der den Halbleiterchip seitlich begrenzenden rinnenartigen Vertiefung durch mechanisches Abtragen von Wafermaterial. Dabei wird das Wafermaterial vorzugsweise durch Sägen abgetragen. Dadurch kann das Auftragen einer Maske und ein umständliches Ätzen der rinnenartigen Vertiefungen entfallen.

Vorteilhaft ist, wenn auf die beim Zerteilen des Wafers im Bereich der rinnenartigen Vertiefungen an dem Halbleiterchip freigelegten Trennflächen eine elektrisch isolierende Schicht aufgebracht wird. Die Seitenflächen des Halbleiterchips können dadurch vollständig elektrisch isoliert werden. Dabei kann die isolierende Schicht gegebenenfalls die anodisch oxidierte Isolationsschicht bereichsweise überdecken. Die Feuchtigkeitsbeständigkeit des Halbleiterchips wird dadurch verbessert.

Bei einer besonders vorteilhaften Ausführungsform der Erfindung wird der Wafer zum gleichzeitigen Freiliegen und anodischen Oxidieren der Seitenwandungen des Halbleiterchips während des Freilegens der Seitenwandungen mit einem Elektrolyten in Verbindung gebracht. Dieser kann dann gleichzeitig auch als Kühlmittel für ein mechanisches Abtragungswerkzeug, beispielsweise ein Sägeblatt dienen.

Bei einer Ausführungsform der Erfindung ist vorgesehen, daß bevor der Halbleiterchip mit dem Elektrolyten in Verbindung gebracht wird, die für die Funktion des Halbleiterchips erforderliche Struktur elektrisch isoliert und/oder mit einer gegen den Elektrolyten chemisch beständigen Schicht versehen wird. Zum elektrischen Isolieren der Oberfläche der Struktur kann beispielsweise in üblicher Weise eine Siliziumdioxid-Schicht auf dem Halbleiterchip aufgebracht werden.

Der Halbleiterchip kann nach dem Herstellen der Isolationsschicht in eine an den Halbleiterchip formangepaßte Aufnahme eines vorzugsweise optisch transparenten Trägerplättchens eingesetzt werden, wobei der Halbleiterchip mit einer wenigstens eine als oberflächenaktiver Sensor ausgebildete Struktur aufweisenden flachseitigen Oberfläche in der Oberflächenebene einer an die Aufnahme angrenzenden flachseitigen Oberfläche des Trägerplättchens angeordnet wird. Ein solcher Halbleiterchip kann beispielsweise als mikroskopierbarer Biosensor verwendet werden, indem auf der in einer Ebene mit der Oberlächenebene des Trägerplättchens angeordneten flachseitigen Oberfläche des Halbleiterchips biologische Zellen in einem Nährmedium adhärent angelagert werden. Die Zellen können dann durch ein Mikroskop optisch beobachtet werden und gleichzeitig können mittels der auf dem Halbleiterchip befindlichen Strukturen Messungen an den Zellen und/oder dem Nährmedium durchgeführt werden. Da die an den Seitenwandungen befindliche Isolationsschicht durch anodische Oxidation des Halbleitermaterials hergestellt wird, wird ein Überstehen der Isolationsschicht über die flachseitige Oberflächenebene des Halbleiterchips vermieden. Somit ergibt sich an der Oberfläche des Halbleiterchips eine ebene Fläche ohne Überstände, die eine Fortsetzung der Oberflächenebene des Trägerplättchens bildet. Biologische Zellen können sich dann besonders gut an der Oberfläche des Halbleiterchips und des Trägersplättchens anlagern.

Nachfolgend sind Ausführungsbeispiele der Erfindung anhand der Zeichnung näher erläutert. Es zeigen:
- Fig. 1: einen Querschnitt durch einen Wafer, in dessen elektrisch aktive Oberfläche Vertiefungen eingebracht wurden, welche die Seitenwandungen von Halbleiterchips bereichsweise freilegen,
- Fig. 2: der in Fig. 1 gezeigte Wafer beim anodischen Oxidieren der Seitenwandungen der Halbleiterchips,
- Fig. 3: eine Darstellung ähnlich Fig. 1, wobei jedoch die Seitenwandungen des Halbleiterchips eine oberflächennahe anodische Oxidationsschicht als elektrische Isolation aufweisen,
- Fig. 4: der in Fig. 3 gezeigte Wafer nach dem Heraustrennen der Halbleiterchips aus dem Waferverbund und
- Fig. 5: einen Wafer, bei dem die Seitenwandungen der Halbleiterchips während des Freilegens der Seitenflächen anodisch oxidiert werden.

Bei einem Verfahren zum Herstellen einer Vielzahl von Halbleiterchips wird ein Wafer 1 mit einer Vielzahl von Strukturen 2 versehen, die jeweils für die elektrische und/oder optische Funktion der einzelnen Halbleiterchips 3 erforderlich sind. Dabei werden die Strukturen 2 mit an sich bekannten Methoden der Halbleitertechnik hergestellt, beispielsweise mittels Maskentechnik, durch Sputtern und/oder Oxidieren der Oberfläche des Wafers 1.

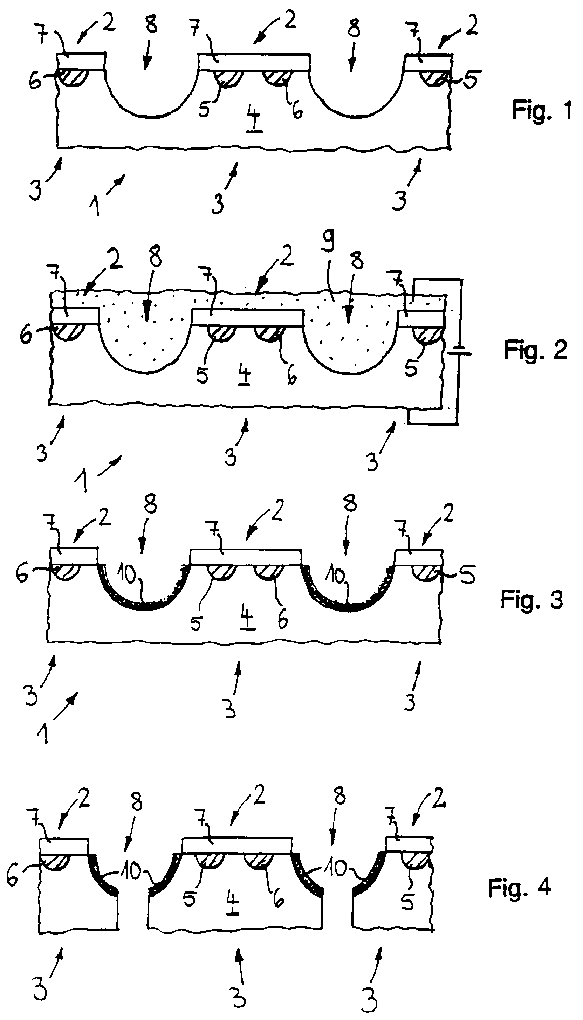

Wie aus Fig. 1 erkennbar ist, umfaßt die Struktur 2 der einzelnen Halbleiterchips 3 jeweils einen ionenselektiven Feldeffekttransistor, der in das Silicium-Substrat 4 des Wafers 1 diffundierte Drain- und Source-Zonen 5, 6 mit zu dem Substrat 4 entgegengesetztem Leitungstyp aufweist. Darüber befindet sich eine Silicumdioxid-Schicht 7, welche die flachseitige Oberfläche des Wafers 1 bildet und diese galvanisch gegen das Substrat 4 isoliert. Die den Drain- und Source-Zonen 5, 6 abgewandte außenseitige Oberfläche der Siliciumdioxid-Schicht 7 bildet eine elektrisch aktive Sensorschicht, mittels welcher der Feldeffekttransistor durch Influenz steuerbar ist. So kann die elektrische Leitfähigkeit zwischen der Drain-Zone 5 und der Source-Zone 6 beispielsweise durch an der Oberfläche Siliciumdioxid-Schicht 7 befindliche, in einem Fluid enthaltene Ionen beeinflußt werden.

Nach dem Herstellen der für die Funktion der Halbleiterchips 3 erforderlichen Strukturen 2 werden im Umgrenzungsbereich der Halbleiterchips 3 deren Seitenwandungen durch Einbringen von rinnenartigen Vertiefungen 8 in die benachbart zu den Strukturen 2 angeordnete flachseitige Oberfläche des Wafers 1 mittels eines Sägewerkzeuges freigelegt. Dann wird an der Oberfläche des Wafers 1 ein die Vertiefungen 8 ausfüllender Elektrolyt 9 deponiert. Als Elektrolyt 9 kann beispielsweise Schwefelsäure, Oxalsäure oder in Wasser gelöstes Kaliumpermanganat verwendet werden. Zum anodischen Oxidieren der durch die Vertiefungen 8 freigelegten Seitenwandungen der Halbleiterchips 3 wird zwischen dem Elektrolyt 9 und dem Substrat 4 des Wafers 1 eine Anodisierspannung angelegt, die beispielsweise einige Volt betragen kann. Nach einer Zeit von einigen Minuten ist die an der Oberfläche der Seitenwandung befindliche Halbleiterschicht in eine anodische Oxidschicht umgewandelt, das eine elektrische Isolationsschicht 10 bildet. Dabei bildet sich die Isolationsschicht 10 nur an den Seitenwandungen der Halbleiterchips 3, da das elektrisch leitfähige Halbleiter-Substrat 4 nur dort mit dem Elektrolyten 9 in Berührung kommt. Die im Bereich der Strukturen 2 befindliche, die Siliciumdioxid-Schicht 7 aufweisende flachseitige Oberfläche des Wafers 1 wird dagegen durch den Elektrolyten 9 nicht verändert.

Nach dem Fertigstellen der Isolationsschichten 10 werden die Halbleiterchips 3 durch Zertrennen des Wafers 1 entlang der rinnenartigen Vertiefungen 8 von dem Waferverbund abgelöst. Das Vereinzeln der Halbleiterchips 3 kann beispielsweise durch einen Sägeschnitt in der rinnenartigen Vertiefung 8 erfolgten, wobei die breite dieses Sägeschnitts kleiner ist als die breite des Sägeschnitts, mit dem die Vertiefung 8 in das Halbleitersubstrat 4 eingebracht wurde (Fig. 4). Die beim Vereinzeln der Halbleiterchips 3 im Bereich der rinnenartigen Vertiefung 8 entstehende Trennfläche kann gegebenenfalls durch Aufbringen einer elektrisch isolierenden Schicht, zum Beispiel einer Kunststoffschicht isoliert werden. Wie aus Fig. 4 erkennbar ist, schließt die elektrische Isolationsschicht 10 bündig mit der an der flachseitigen Oberfläche der Halbleiterchips 3 befindlichen Siliciumdioxid-Schicht 7 ab. Es wird also ein Überstehen der elektrischen Isolationsschicht 10 über die elektrisch aktive, flachseitige Oberfläche der Halbleiterchips 3 vermieden.

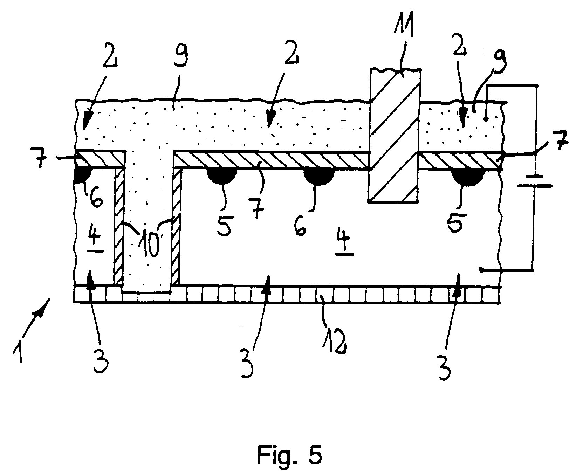

Bei dem in Fig. 5 gezeigten Ausführungsbeispiel wird das Vereinzeln der Halbleiterchips 3 und das Isolieren der Seitenwandungen der Halbleiterchips 3 mittels anodischer Oxydation in einem Arbeitsschritt durchgeführt. An der Oberfläche des Wafers 1 wird dazu während des Freilegens der Seitwandungen der Halbleiterchips 3 durch Sägeschnitte ein Elektrolyt 9 deponiert. Zwischen dem Elektrolyt 9 und dem Substrat 4 des Wafers 1 wird eine Anodisierspannung von einigen Volt angelegt. Während des Freiliegens der Seitenwandungen der Halbleiterchips 3 oxidiert der Elektrolyt 9 das an bereits freigelegten Seitwandungsbereichen befindliche Substrat 4. Der Elektrolyt 9 bewirkt gleichzeitig eine Kühlung des Sägewerkzeugs 11. In Fig. 5 ist deutlich erkennbar, daß während des Freilegens einer der Seitenwandungen eines Halbleiterchips 3 an einer anderen, bereits freigelegten Seitenwandung bereits eine elektrische Isolationsschicht 10 gebildet ist.
Erwähnt werden soll noch, daß der Wafer 1 während des anodischen Oxidierens der Isolationsschicht 10 mit seiner der Struktur 2 abgewandten Rückseite an einer Haftfolie 12 anhaftet, welche die Rückseite des Wafers 1 gegen den Elektrolyten 9 abdichtet. Die Haftfolie 12 wird beim Vereinzeln der Halbleiterchips 3 von diesen abgelöst.

## Patentansprüche

1. Verfahren zum Herstellen eines Halbleiterchips (3), wobei ein Wafer (1) mit der für die Funktion des Halbleiterchips (3) erforderlichen Struktur (2) versehen wird, wobei danach im Umgrenzungsbereich des Halbleiterchips (3) dessen Seitenwandungen zumindest bereichsweise freigelegt werden und wobei die elektrisch leitenden Seitenwandungen des Halbleiterchips (3) mit einer elektrischen Isolationsschicht (10) versehen werden, die durch anodische Oxidation der Seitenwandungen erzeugt wird.

2. Verfahren nach Anspruch 1, dadurch gekennzeichnet, daß die Seitenwandungen des Halbleiterchips (3) durch Einbringen einer rinnenartigen Vertiefung (8) in eine flachseitige Oberfläche des Wafers (1) freigelegt wird, daß der Wafer (1) danach an den Seitenwandungen anodisch oxidiert wird und daß der Wafer (1) anschließend zum Abtrennen des Halbleiterchips (3) vom Wafer (1) entlang der den Halbleiterchip (3) umgrenzenden rinnenartigen Vertiefung (8) zerteilt wird.

3. Verfahren nach Anspruch 1 oder 2, dadurch gekennzeichnet, daß das Freilegen der anodisch zu oxidierenden Seitenwandungen und/oder das Zerteilen des Wafers (1) entlang der den Halbleiterchip (3) seitlich begrenzenden rinnenartigen Vertiefung (8) durch mechanisches Abtragen von Wafermaterial erfolgt.

4. Verfahren nach einem der Ansprüche 1 bis 3, dadurch gekennzeichnet, daß auf die beim Zerteilen des Wafers (1) im Bereich der rinnenartigen Vertiefung (8) an dem Halbleiterchip (3) freigelegten Trennflächen eine elektrisch isolierende Schicht aufgebracht wird.

5. Verfahren nach einem der Ansprüche 1 bis 4, dadurch gekennzeichnet, daß der Wafer (1) zum gleichzeitigen Freilegen und anodischen Oxidieren der Seitenwandungen des Halbleiterchips (3) während des Freilegens der Seitenwandungen mit einem Elektrolyten (9) in Verbindung gebracht wird.

6. Verfahren nach einem der Ansprüche 1 bis 5, dadurch gekennzeichnet, daß bevor der Halbleiterchip mit dem Elektrolyten in Verbindung gebracht wird, die für die Funktion des Halbleiterchips erforderliche Struktur elektrisch isoliert und/oder mit einer gegen den Elektrolyten chemisch beständigen Schicht versehen wird.
